# EUROPEAN PATENT APPLICATION

(11) **EP 4 665 101 A1**
(43) Date of publication of application: **17.12.2025**
(21) Application number: 25180288.0
(22) Date of filing: 02.06.2025
(51) Int. Cl.: H05K 7/20

(54) **HEAT REJECTION SYSTEM**

(30) Priority: 12.06.2024 US 202463659198 P; 23.05.2025 US 202519216982
(71) Applicant: Vertiv Corporation, Westerville, OH 43082 (US)
(72) Inventor: Cole, Andrew Nathan, Westerville, 43082 (US); Schrader, Timothy James, Westerville, 43082 (US)
(74) Representative: Cousens, Nico

(57) **Abstract**

A heat rejection system comprises a first heat rejection unit including a first set of fans and coils; a second heat rejection unit configured to be stacked on top of the first heat rejection unit, wherein the second heat rejection unit includes a second set of fans and coils; one or more central passages configured to connect the first heat rejection unit to the second heat rejection unit, wherein the one or more central passages separate the first heat rejection unit into at least a first section and a second section, wherein the first section includes a first fan and a first coil of the first set of fans and coils and the second section includes a second fan and a second coil of the first set of fans and coils; and an inlet duct configured to communicate with outside and receive fresh ambient air via an opening in the inlet duct, wherein the inlet duct is arranged below the first heat rejection unit and configured to divert the fresh ambient air to at least one of the first heat rejection unit or the second heat rejection unit to be exhausted outside.

## Description

The present application claims the benefit under 35 U.S.C § 119(e) of U.S. Provisional Application No. 63/659,198, filed June 12, 2024.

### TECHNICAL FIELD

The present disclosure generally relates to the field of cooling systems, and more particularly, to a heat rejection system for high efficiency cooling systems.

### BACKGROUND

Cooling systems used for data centers typically include climate control systems to maintain the proper temperature and humidity in the data centers. The climate control systems often include one or more computer room air conditioners (CRACs) coupled to heat rejection devices to provide cooled liquid to the CRACs. Heat rejection devices often transfer heat from the return fluid of the CRACs to a cooler medium, such as outside ambient air. Current heat rejection devices are limited by coil surface area and limitations on fan flow and recirculation due to the space constraints of the buildings themselves. Further, the quantity of cooling units able to be installed is limited. As such, there is a need for a heat rejection device to provide high density heat rejection which cures the shortfalls of the previous approaches.

### SUMMARY

A heat rejection system is disclosed, in accordance with one or more embodiments of the present disclosure. In embodiments, the heat rejection system includes: a first heat rejection unit including a first set of fans and coils; a second heat rejection unit configured to be stacked on top of the first heat rejection unit, where the second heat rejection unit includes a second set of fans and coils; one or more central passages configured to connect the first heat rejection unit to the second heat rejection unit, where the one or more central passages separate the first heat rejection unit into at least a first section and a second section, where the first section includes a first fan and a first coil of the first set of fans and coils and the second section includes a second fan and a second coil of the first set of fans and coils; and an inlet duct configured to communicate with outside and receive fresh ambient air via an opening in the inlet duct, where the inlet duct is arranged below the first heat rejection unit and configured to divert the fresh ambient air to at least one of the first heat rejection unit or the second heat rejection unit to be exhausted outside.

A cooling system is disclosed, in accordance with one or more embodiments of the present disclosure. In embodiments, the cooling system includes: a first heat rejection system; and a second heat rejection system, where the first heat rejection system is arranged proximate to the second heat rejection system. In embodiments, each of the first heat rejection system and the second heat rejection system include: a first heat rejection unit including a first set of fans and coils; a second heat rejection unit configured to be stacked on top of the first heat rejection unit, where the second heat rejection unit includes a second set of fans and coils; one or more central passages configured to connect the first heat rejection unit to the second heat rejection unit, where the one or more central passages separate the first heat rejection unit into at least a first section and a second section, where the first section includes a first fan and a first coil of the first set of fans and coils and the second section includes a second fan and a second coil of the first set of fans and coils; and an inlet duct configured to communicate with outside and receive fresh ambient air via an opening in the inlet duct, where the inlet duct is arranged below the first heat rejection unit and configured to divert the fresh ambient air to at least one of the first heat rejection unit or the second heat rejection unit to be exhausted outside.

A cooling system is disclosed, in accordance with one or more embodiments of the present disclosure. In embodiments, the cooling system includes: a first heat rejection system; and a second heat rejection system, where the first heat rejection system is arranged next to the second heat rejection system, where a void is formed between the first heat rejection system and the second heat rejection system. In embodiments, each of the first heat rejection system and the second heat rejection system include: a first heat rejection unit including a first set of fans and coils; a second heat rejection unit configured to be stacked on top of the first heat rejection unit, where the second heat rejection unit includes a second set of fans and coils; one or more central passages configured to connect the first heat rejection unit to the second heat rejection unit, where the one or more central passages separate the first heat rejection unit into at least a first section and a second section, where the first section includes a first fan and a first coil of the first set of fans and coils and the second section includes a second fan and a second coil of the first set of fans and coils; and an inlet duct configured to communicate with outside and receive fresh ambient air via an opening in the inlet duct, where the inlet duct is arranged below the first heat rejection unit and configured to divert the fresh ambient air to at least one of the first heat rejection unit or the second heat rejection unit to be exhausted outside, where the first heat rejection unit of the first heat rejection system and the first heat rejection unit of the second heat rejection system are connected.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures.
FIG. 1A is a simplified schematic view of a heat rejection system, in accordance with one or more embodiments of present disclosure.
FIG. 1B is a simplified schematic view of a heat rejection system, in accordance with one or more embodiments of present disclosure.
**FIG.** 2A is a simplified block diagram of a cooling system including the heat rejection system of FIGS. 1A-1B, in accordance with one or more embodiments of the present disclosure.
FIG. 2B is a simplified schematic view of a cooling system including the heat rejection system of FIGS. 1A-1B, in accordance with one or more embodiments of the present disclosure.
FIG. 2C is a simplified schematic view of a cooling system including the heat rejection system of FIGS. 1A-1B, in accordance with one or more embodiments of the present disclosure.
FIG. 2D is a simplified schematic view of a cooling system including the heat rejection system of FIGS. 1A-1B, in accordance with one or more embodiments of the present disclosure.
FIG. 2E is a simplified schematic view of a cooling system including the heat rejection system of FIGS. 1A-1B, in accordance with one or more embodiments of the present disclosure.
FIG. 3A is a simplified block diagram top view of a cooling system including the heat rejection system of FIGS. 1A-1B, in accordance with one or more embodiments of the present disclosure.
FIG. 3B is a simplified block diagram top view of a cooling system including the heat rejection system of FIGS. 1A-1B, in accordance with one or more embodiments of the present disclosure.
FIG. 3C is a simplified block diagram top view of a cooling system including the heat rejection system of FIGS. 1A-1B, in accordance with one or more embodiments of the present disclosure.
FIG. 4 is a simplified schematic view of a heat rejection system in a side-by-side configuration, in accordance with one or more embodiments of present disclosure.

### DETAILED DESCRIPTION

Reference will now be made in detail to the subject matter disclosed, which is illustrated in the accompanying drawings.

Embodiments of the present disclosure are directed to a heat rejection system. More particularly, embodiments of the present disclosure are directed to a new and novel heat rejection system in a specific arrangement configured to increase a density of rejected heat from the heat rejection system at rooftops (or data center halls). For example, the heat rejection system may include one or more vertically stacked heat rejection units configured to increase rooftop density. In this regard, the heat rejection system may allow multi-floor data centers to increase the number of floors within the data center and maximize server usage. Further, the heat rejection system may decrease recirculation. For example, the one or more heat rejection units of the heat rejection system may bring in fresh ambient air through inlet ducts.

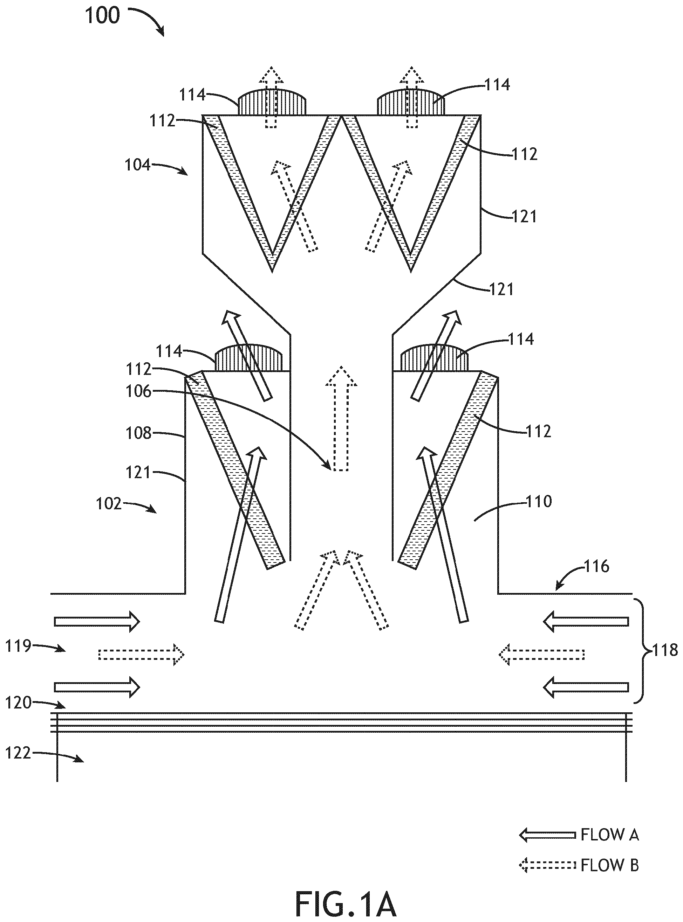

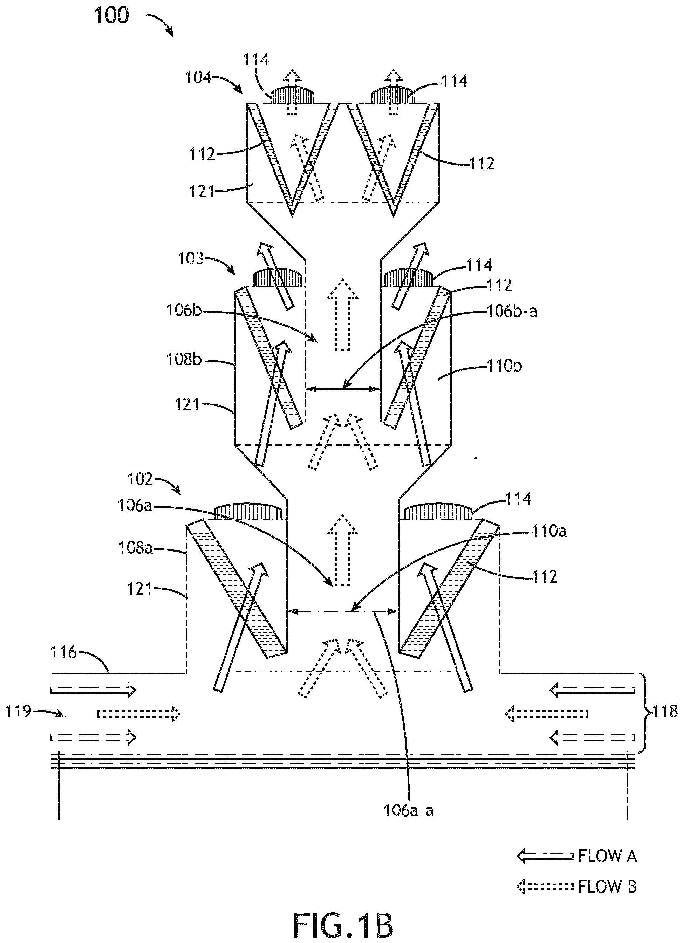

FIGS. 1A and 1B illustrate simplified schematics of a heat rejection system 100, in accordance with one or more embodiments of the present disclosure.

The heat rejection system 100 may include one or more heat rejection units. For example, as shown in FIG. 1A, the heat rejection system 100 may include at least a lower heat rejection unit 102 and an upper heat rejection unit 104. For instance, the upper heat rejection unit 104 may be stacked on top of the lower heat rejection unit 102 to form a vertical stack of heat rejection units. By way of another example, as shown in FIG. 1B, the heat rejection system 100 may further include one or more intermediate heat rejection units 103. For instance, the upper heat rejection unit 104 may be stacked on top of the intermediate heat rejection unit 103 that is stacked on top of the lower heat rejection unit 102 to form a vertical stack of heat rejection units.

It is contemplated herein that the vertical stack of heat rejection units may increase the vertical height of the heat rejection system 100 to thereby increase density heat rejection on the rooftop and allow white spaces to maximize server usage.

The heat rejection system 100 may include one or more central air passages 106. Referring to FIG. 1A, the heat rejection system 100 may include a single central air passage 106 that passes through the center of at least the lower heat rejection unit 102. For example, the central air passage 106 may connect the lower heat rejection unit 102 to the upper heat rejection unit 104. For instance, the one or more central air passages 106 may separate at least the lower heat rejection unit 102 into at least a first section 108 and a second section 110, where the central air passage 106 is arranged in between the first section 108 and the second section 110. In this regard, one or more sidewalls of the central air passage 106 may at least partially define the first section 108 and the second section 110 within the lower heat rejection unit 102.

Referring to FIG. 1B, the heat rejection system 100 may include a plurality of central air passages 106 including at least a first central air passage 106a and a second central air passage 106b. For example, the first central air passage 106a may pass through the center of the one or more intermediate heat rejection units 103. In this regard, the first central air passage 106a may connect the lower heat rejection unit 102 to the one or more intermediate heat rejection units 103. For instance, the first central air passage 106a may separate the lower heat rejection unit 102 into a first section 108a and a second section 110a, where the first central air passage 106a is arranged in between the first section 108a and the second section 110a of the lower heat rejection unit 102. In this regard, one or more sidewalls of the first central air passage 106a may at least partially define the first section 108a and the second section 110a within the lower heat rejection unit 102.

By way of another example, the second central air passage 106b may connect the one or more intermediate heat rejection units 103 to the upper heat rejection unit 104. For instance, the second central air passage 106b may separate the one or more intermediate heat rejection units 103 into a first section 108b and a second section 110b, where the second central air passage 106b is arranged in between the first section 108b and the second section 110b of the intermediate heat rejection unit 103. In this regard, one or more sidewalls of the second central air passage 106b may at least partially define the first section 108b and the second section 110b within the intermediate heat rejection unit 103.

In the above example, as shown in FIG. 1B, the first central air passage 106a may have a first width 106a-a that is greater than a second width 106b-a of the second central air passage 106b. However, it is contemplated herein that the size is not limited thereto, such that the first width 106a-a may be smaller than or equal to the second width 106b-a. For instance, the width at any given point in the air stream may depend on the amount of airflow through that portion. In the case of a vertical stack, there may be more overall airflow through the bottom portion and less as it goes higher as air is diverted through the various coils/fans.

Each heat rejection unit of the heat rejection system 100 may include one or more coils 112 and one or more fans 114.

For example, as shown FIG. 1A, the first section 108 of the lower heat rejection unit 102 may include a first set of coils 112 and fans 114 and the second section 110 of the lower heat rejection unit 102 may include a second set of coils 112 and fans 114, where the coils 112 and fans 114 of the respective sections 108, 110 of the lower heat rejection unit 102 are separated by the central air passage 106. For instance, in a non-limiting example, the first section 108 may include a first coil 112 and a first fan 114 and the second section 110 may include a second coil 112 and a second fan 114. Further, as shown in FIG. 1A, the upper heat rejection unit 104 may include one or more coils 112 and one or more fans 114. For instance, in a non-limiting example, the upper heat rejection unit 104 may include four coils 112 and two fans 114 (e.g., two coils per fan).

By way of another example, as shown FIG. 1B, the first section 108a of the lower heat rejection unit 102 may include a first set of coils 112 and fans 114 and the second section 110a of the lower heat rejection unit 102 may include a second set of coils 112 and fans 114, where the coils 112 and fans 114 of the respective sections 108a, 110a of the lower heat rejection unit 102 are separated by the central air passage 106a. For instance, in a non-limiting example, the first section 108a may include a first coil 112 and a first fan 114 and the second section 110a may include a second coil 112 and a second fan 114. Further, as shown FIG. 1B, the first section 108b of the intermediate heat rejection unit 103 may include a first set of coils 112 and fans 114 and the second section 110b of the intermediate heat rejection unit 103 may include a second set of coils 112 and fans 114, where the coils 112 and fans 114 of the respective sections 108b, 110b of the intermediate heat rejection unit 102 are separated by the central air passage 106b. For instance, in a non-limiting example, the first section 108b may include a first coil 112 and a first fan 114 and the second section 110b may include a second coil 112 and a second fan 114. Further, as shown in FIG. 1B, the upper heat rejection unit 104 may include one or more coils 112 and one or more fans 114. For instance, in a non-limiting example, the upper heat rejection unit 104 may include four coils 112 and two fans 114 (e.g., two coils per fan).

Although FIGS. 1A and 1B depict a specific number, size, and configuration of coils 112 and fans 114, it is contemplated herein that the heat rejection system 100 may include any number, size, and configuration of coils 112 (e.g., angled, slab, "v", and the like) and fans 114 suitable for the cooling needs of the data center.

The lower heat rejection unit 102 may be installed on a solid raised floor 116 (or mezzanine structure 116) to form an inlet duct 118. In some instances, the inlet duct 118 may be placed below or inside the lower heat rejection unit 102. The inlet duct 118 may be configured to communicate with the outside and receive fresh ambient air to the heat rejection system 100.

The inlet duct 118 may be defined by at least a portion of the solid raised floor 116 (or mezzanine structure 116) and a roof 120 (or floor 120) of the building 122, where the sides of the inlet duct 118 are open to form an opening 119. As such, fresh ambient air from outside may enter the heat rejection system 100 via the opening 119 within the inlet duct 118 and may be diverted throughout the lower heat rejection unit 102 and upper heat rejection unit 104. For example, as shown in FIG. 1A, a first air flow (Flow A) may enter the inlet duct 118 via the opening 119 and be diverted to the first section 108 and the second section 110 of the lower heat rejection unit 102, where the first air flow (Flow A) represented by solid line arrows may be exhausted via the fans 114 of the lower heat rejection unit 102. Further, as shown in FIG. 1B, a second air flow (Flow B) represented by dotted line arrows, may enter the inlet duct 118 via the opening 119 and be diverted to through the central passage 106 the upper heat rejection unit 104, where the second air flow (Flow B) may be exhausted via the fans 114 of the upper heat rejection unit 104.

The heat rejection units may include one or more air block walls 121 (or panels) to prevent outside air from entering the heat rejection system 100. The one or more air block walls 121 may cause air within the heat rejection units to be diverted in a specific way. As such, recirculation is decreased (e.g., nearly zero recirculation). For example, as shown in FIG. 1A, the first section 108 and the second section 110 of the lower heat rejection unit 102 may include one or more air block walls 121, where the central passage 106 includes one or more air block walls (or sidewalls). Further, as shown in FIG. 1A, the upper heat rejection unit 104 may include one or more air block walls. By way of another example, as shown in FIG. 1B, the first section 108a, b and the second section 110a, b of the lower heat rejection unit 102 and the intermediate heat rejection unit 103 may include one or more air block walls 121, where the central passages 106a, 106b include one or more air block walls (or sidewalls). Further, as shown in FIG. 1B, the upper heat rejection unit 104 may include one or more air block walls.

Although FIGS. 1A-1B depict a specific number and configuration (e.g., arrangement, shape, size, or the like) of heat rejection units. It is contemplated herein, that the heat rejection system 100 may include any number and configuration of heat rejection units. For example, as previously discussed herein with reference to FIG. 1A, the heat rejection system may include a single unit. By way of another example, as previously discussed herein with reference to FIG. 1B, the heat rejection system may include two or more units.

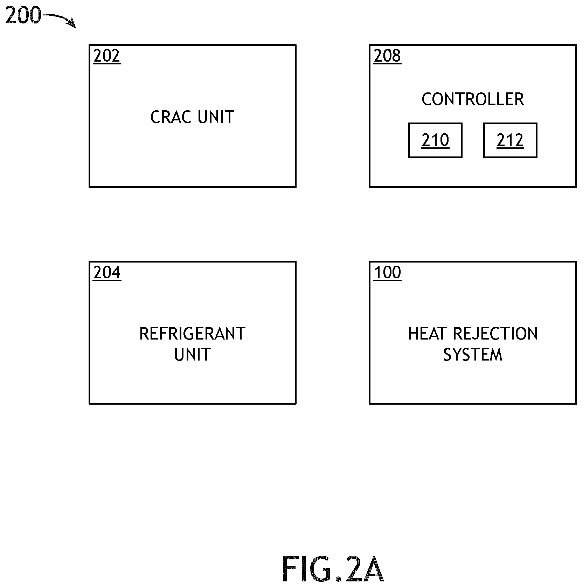

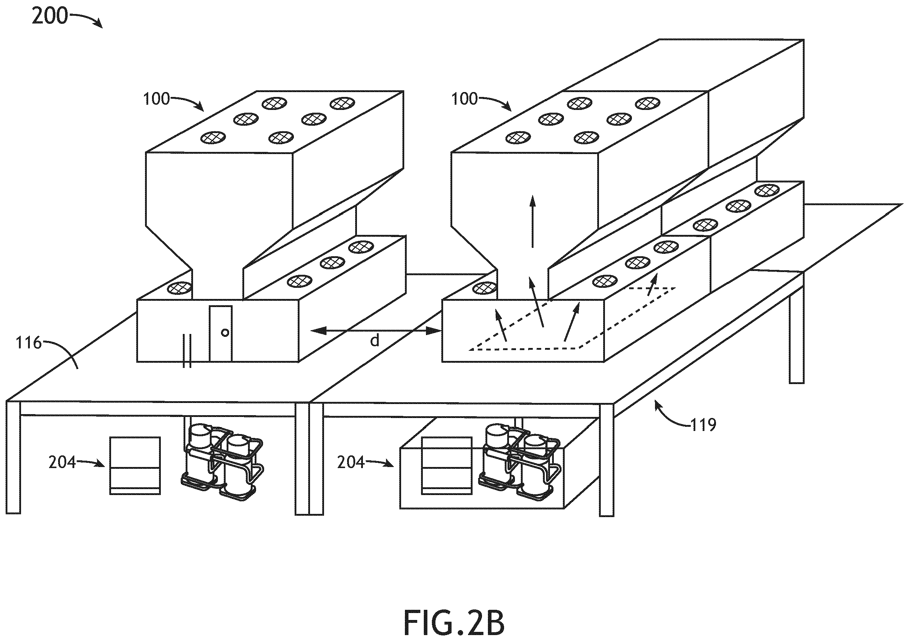

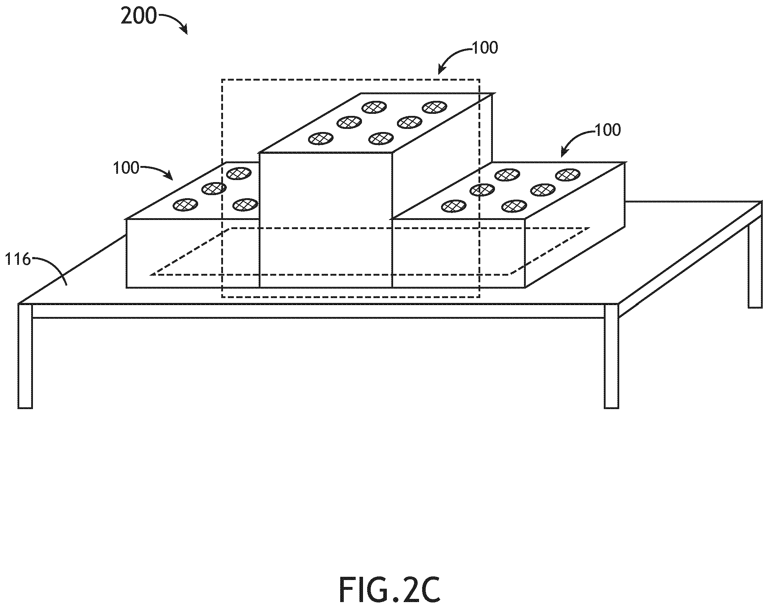

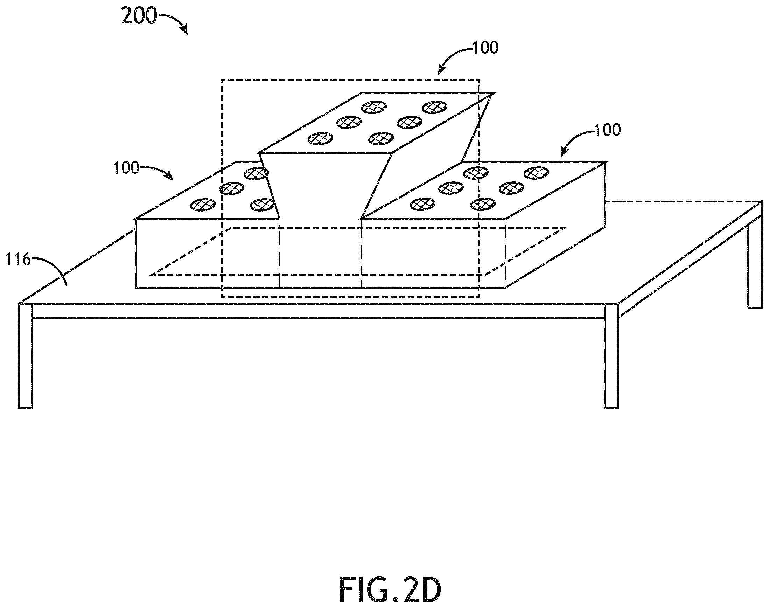

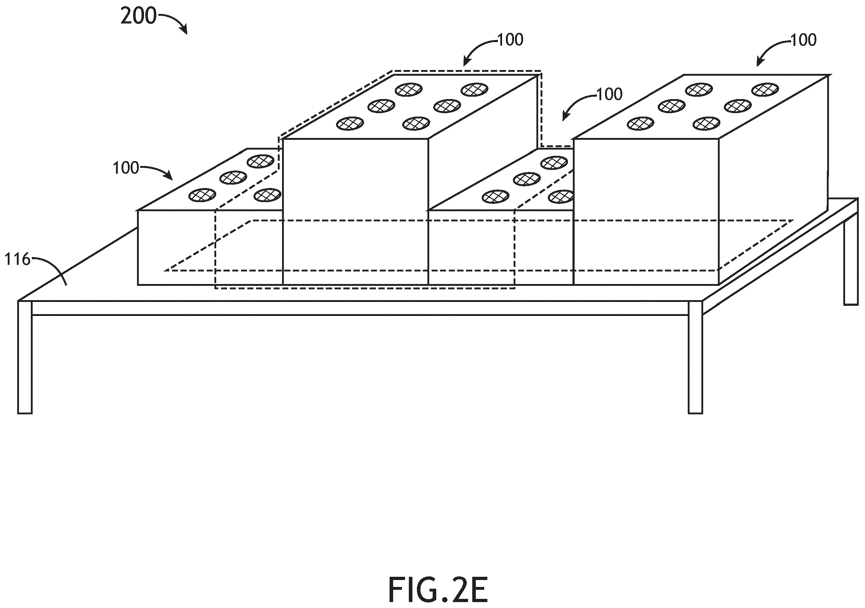

FIG. 2A illustrates a simplified block diagram of a cooling system 200 including the heat rejection system 100, in accordance with one or more embodiments of the present disclosure. FIG. 2B illustrates a simplified schematic of the cooling system 200 including the heat rejection system 100, in accordance with one or more embodiments of the present disclosure. FIG. 2C illustrates a simplified schematic of the cooling system 200 including the heat rejection system 100, in accordance with one or more embodiments of the present disclosure. FIG. 2D illustrates a simplified schematic of the cooling system 200 including the heat rejection system 100, in accordance with one or more embodiments of the present disclosure. FIG. 2E illustrates a simplified schematic of the cooling system 200 including the heat rejection system 100, in accordance with one or more embodiments of the present disclosure.

The cooling system 200 may include one or more computer room air conditioner (CRAC) units 202. For example, the one or more CRAC units 202 may be coupled to one or more heat rejection systems 100 to provide cooled liquid to the respective one or more CRAC units 202. Further, the heat rejection systems 100 may transfer heat from the return fluid from the one or more CRAC units 202 to a cooler medium, such as outside ambient air.

It is contemplated that the one or more CRAC units 202 may include any suitable cooling technology. For example, the one or more CRAC units 202 may include, but are not limited to, air or liquid cooled heat exchangers, or a combination or air and liquid cooled heat exchangers.

Referring to FIG. 2B, the cooling system 200 may include at least a first heat rejection system 100 arranged proximate to (or next to) a second heat rejection system 100. For example, as shown in FIG. 2B, the first heat rejection system 100 may be spaced a predetermined distance d from the second heat rejection system 100. Further, the solid floor 116 of the first heat rejection system 100 may be flush with the solid floor 116 of the second heat rejection system 100 such that there is no gap between the top surfaces of the respective solid floors 116.

Referring to FIGS. 2C and 2D, the cooling system 200 may include at least a first heat rejection system 100 arranged proximate to (or next to) a second heat rejection system 100 and a third heat rejection system 100. For example, as shown in FIGS. 2C and 2D, the first heat rejection system 100 may be arranged directly adjacent to the second heat rejection system 100 and the third heat rejection system, such that there is no gap between the respective heat rejection systems 100. In this regard, the cooling system 200 may be a compact cooling system to accommodate small footprints. In one instance, the first, second, and third heat rejection systems 100 may be on a single solid floor 116, as shown in FIGS. 2C-2D. In another instance, each system may be on a respective solid floor 116, where the solid floor 116 of the first heat rejection system 100 may be flush with the solid floor 116 of the second heat rejection system 100 and the third heat rejection system 100, such that there is no gap between the respective solid floors 116.

Referring to FIG. 2E, the cooling system 200 may include at least a first heat rejection system 100 arranged proximate to (or next to) a second heat rejection system 100, where the second heat rejection system 100 is arranged proximate to (or next to) a third heat rejection system 100 arranged proximate to (or next to) a fourth heat rejection system 100. For example, as shown in FIG. 2E, the four heat rejection systems 100 may be arranged directly adjacent to one another, such that there is no gap between the respective heat rejection systems 100. In this regard, the cooling system 200 may be a compact cooling system to accommodate small footprints. In one instance, the first, second, third, and fourth heat rejection systems 100 may be on a single solid floor 116, as shown in FIG. 2E. In another instance, each system may be on a respective solid floor 116, where the solid floor 116 of the first heat rejection system 100 may be flush with the solid floor 116 of the second heat rejection system 100, and so on, such that there is no gap between the respective solid floors 116.

It is contemplated herein that the configuration of the heat rejection systems 100 may be modified, therefore such configurations shown in FIGS. 2A-2E are provided merely for illustrative purposes and shall not be construed as limiting the scope of the present disclosure. For example, as shown in FIGS. 2C and 2E, the heat rejection systems 100 may be substantially rectangular. By way of another example, as shown in FIG. 2D, the heat rejection systems 100 may include a rectangular base with the trapezoidal top.

It is contemplated that the pattern of heat rejection systems 100 may be infinitely modified based on the floor plan of the building (e.g., surface area of the roof, access mechanisms, and the like) and/or the cooling needs of the user/customer.

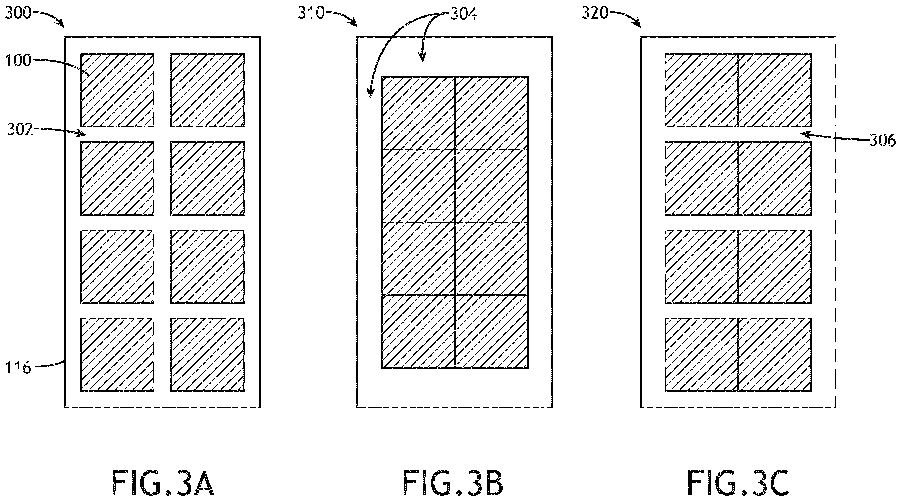

For example, FIGS. 3A-3C depicts one or more arrangements 300, 310, 320 of the heat rejection system 100. In a first arrangement 300, as shown in FIG. 3A, the heat rejection system 100 may be arranged such that there is an access aisle 302 between the respective systems 100. In a second arrangement 310, as shown in FIG. 3B, the heat rejection system 100 may be arranged such that there is an access aisle 304 around the perimeter of the respective systems 100. In a third arrangement 320, as shown in FIG. 3C, the heat rejection system 100 may be arranged such that there is an access aisle 306 below the respective systems 100.

In some instances, the heat rejection systems 100 of the cooling system 200 may be coupled together via one or more fastening members to provide additional support. In this regard, the heat rejection systems 100 may be strapped together to provide additional support and protection from environmental factors (e.g., wind, earthquakes, tornadoes, or the like).

The cooling system 200 may include one or more refrigerant units 204. For example, the one or more refrigerant units 204 may provide refrigerant to the one or more CRAC units 202. In some instances, the one or more CRAC units 202 may be phase change refrigerant air conditioning systems having refrigerant compressors, such as a direct-exchange (DX) system. It is contemplated herein that the heat rejection units may also be used as dry coolers to reject head from a water-based cooling system. It is contemplated herein that mechanicals may be installed below or inside the refrigerant units 204.

The cooling system 200 may further include one or more controllers 208 including one or more processors 210 and memory 212. The one or more controllers 208 may adjust one or more settings of the one or more components of the cooling system 200 based on one or more factors (e.g., outdoor temperature, or the like).

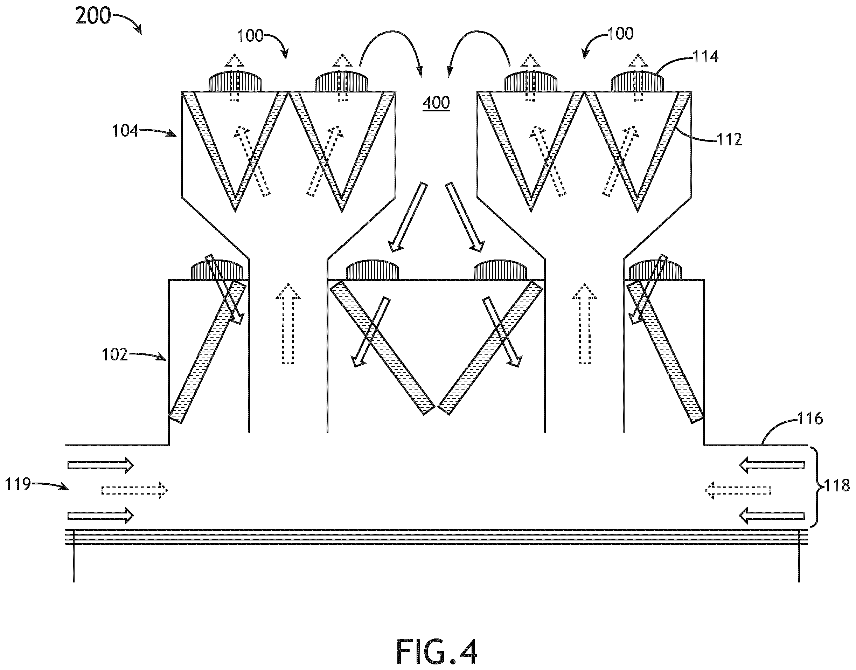

FIG. 4 illustrates a simplified schematic of side-by-side heat rejection systems 200, in accordance with one or more embodiments of the present disclosure. It is contemplated herein that when the heat rejection systems 100 are installed side-by-side, a void 400 above the lower fans 114 is formed. During cold ambient air, the lower fans 114 can be operated in reverse. As such, the system 200 is able to intentionally recirculate the warmer air from other rejection systems 100 and mixed with fresh ambient air received via the opening 119 (through the duct 118), where the lower heat rejection units 102 are connected to allow for such mixing. In this regard, the air temperature into the coils 112 is increased, improving system pressures when air temperatures are cold.

Also disclosed are the following numbered clauses:
1. A cooling system comprising: a first heat rejection system; and a second heat rejection system, wherein the first heat rejection system is arranged next to the second heat rejection system, wherein a void is formed between the first heat rejection system and the second heat rejection system, wherein each of the first heat rejection system and the second heat rejection system comprise: a first heat rejection unit including a first set of fans and coils; a second heat rejection unit configured to be stacked on top of the first heat rejection unit, wherein the second heat rejection unit includes a second set of fans and coils; one or more central passages configured to connect the first heat rejection unit to the second heat rejection unit, wherein the one or more central passages separate the first heat rejection unit into at least a first section and a second section, wherein the first section includes a first fan and a first coil of the first set of fans and coils and the second section includes a second fan and a second coil of the first set of fans and coils; and an inlet duct configured to communicate with outside and receive fresh ambient air via an opening in the inlet duct, wherein the inlet duct is arranged below the first heat rejection unit and configured to divert the fresh ambient air to at least one of the first heat rejection unit or the second heat rejection unit to be exhausted outside, wherein the first heat rejection unit of the first heat rejection system and the first heat rejection unit of the second heat rejection system are connected.
2. The cooling system of clause 1, wherein the fans of each of the first heat rejections unit are operated in reverse to intentionally recirculate warmer air from one of the first heat rejection system or the second heat rejection system and mix with the fresh ambient air received via the opening in the inlet duct.

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A heat rejection system (100) comprising:
a first heat rejection unit (102) including a first set of fans (114) and coils (112);
a second heat rejection unit (104) configured to be stacked on top of the first heat rejection unit, wherein the second heat rejection unit includes a second set of fans (114) and coils (112);
one or more central passages (106) configured to connect the first heat rejection unit to the second heat rejection unit, wherein the one or more central passages separate the first heat rejection unit into at least a first section (108) and a second section (110), wherein the first section includes a first fan and a first coil of the first set of fans and coils and the second section includes a second fan and a second coil of the first set of fans and coils; and
an inlet duct configured to communicate with outside and receive fresh ambient air via an opening in the inlet duct, wherein the inlet duct is arranged below the first heat rejection unit and configured to divert the fresh ambient air to at least one of the first heat rejection unit or the second heat rejection unit to be exhausted outside.

2. The heat rejection system of claim 1, wherein the first heat rejection unit is arranged on one of a solid floor (116) or a mezzanine structure (116) to form the inlet duct (118), and optionally wherein the one of the solid floor or the mezzanine structure is installed on a roof (120) of a building (122).

3. The heat rejection system of any preceding claim, further comprising:
a third heat rejection unit configured to be stacked on top of the second heat rejection unit, wherein the first heat rejection unit includes a first central passage of the one or more central passages and the second heat rejection unit includes a second central passage of the one or more central passages, and wherein the first central passage connects the first heat rejection unit to the second heat rejection unit and the second central passage connects the second heat rejection unit to the third heat rejection unit.

4. The heat rejection system of claim 3, wherein the first central passage has a first width and the second central passage has a second width, wherein the first width is greater than the second width.

5. The heat rejection system of any preceding claim, wherein the first heat rejection unit and the second heat rejection unit include one or more air block walls (121) configured to prevent outside air from entering the heat rejection system.

6. A cooling system (200) comprising:
a first heat rejection system (100); and
a second heat rejection system (100), wherein the first heat rejection system is arranged proximate to the second heat rejection system,
wherein each of the first heat rejection system and the second heat rejection system is a heat rejection system according to any preceding claim.

7. The cooling system of claim 6, further comprising:
one or more computer room air conditioner "CRAC" units (202) coupled to the first heat rejection system and the second heat rejection system, wherein the first heat rejection system and the second heat rejection system are configured to provide one of cooled air or cooled liquid to the one or more CRAC units.

8. The cooling system of claim 6 or 7, wherein the first heat rejection unit of the first heat rejection system and the first heat rejection unit of the second heat rejection system are each arranged on one of a solid floor or a mezzanine structure to form the inlet duct, and optionally wherein the one of the solid floor or the mezzanine structure is installed on a roof of a building.

9. The cooling system of claim 8, wherein the first heat rejection system is arranged a predetermined distance from the second heat rejection system.

10. The cooling system of claim 9, wherein a top surface of the solid floor or the mezzanine structure of the first heat rejection system and the second heat rejection system are flush.

11. The cooling system of claim 6 or 7, wherein the first heat rejection unit of the first heat rejection system and the first heat rejection unit of the second heat rejection system are arranged on one of a solid floor or a mezzanine structure to form the inlet duct, and optionally wherein the first heat rejection system is arranged substantially flush with the second heat rejection system.

12. The cooling system of any of claims 7 to 11, wherein each of the first heat rejection system and the second heat rejection system further comprise:
a third heat rejection unit configured to be stacked on top of the second heat rejection unit, wherein the first heat rejection unit includes a first central passage of the one or more central passages and the second heat rejection unit includes a second central passage of the one or more central passages, and wherein the first central passage connects the first heat rejection unit to the second heat rejection unit and the second central passage connects the second heat rejection unit to the third heat rejection unit.

13. The cooling system of claim 12, wherein the first central passage has a first width and the second central passage has a second width, wherein the first width is greater than the second width.

14. The cooling system of any preceding claim, wherein the first heat rejection unit and the second heat rejection unit include one or more air block walls configured to prevent outside air from entering the first heat rejection system and the second heat rejection system.

15. The cooling system of claim 12 or claims 13 or 14 when dependent on claim 12, wherein the third heat rejection unit includes one or more air block walls configured to prevent outside air from entering the first heat rejection system and the second heat rejection system.
